# FASCICULE DE BREVET EUROPEEN

(11) **EP 0 523 793 B1**
(45) Date de publication et mention de la délivrance du brevet: **22.11.1995**
(21) Numéro de dépôt: 92202104.3
(22) Date de dépôt: 10.07.1992
(51) Int. Cl.: D06F 75/26

(54) **Fer à repasser muni d'un détecteur de la nature des tissus**
Bügeleisen mit Textilsortenfühler
Iron with detector for nature of textile

(30) Priorité: 19.07.1991 FR 9109131
(43) Date de publication de la demande: 20.01.1993
(73) Titulaire: LABORATOIRES D'ELECTRONIQUE PHILIPS, 94450 Limeil-Brévannes (FR); Philips Electronics N.V., 5621 BA Eindhoven (NL)
(72) Inventeur: Hazan, Jean-Pierre, Société Civile S.P.I.D., F-75008 Paris (FR); Polaert, Rémy, Société Civile S.P.I.D., F-75008 Paris (FR); Nagel, Jean-Louis, Société Civile S.P.I.D., F-75008 Paris (FR)
(74) Mandataire: Landousy, Christian

(56) Documents cités:
- DE-A- 2 548 588
- DE-A- 3 444 348
- US-A- 2 527 779
- PATENT ABSTRACTS OF JAPAN vol. 14, no. 314 (C-737)(4257) 5 Juillet 1990 & JP-A-2109600 (MATSUSHITA ELECTRIC IND. CO. LTD)

## Description

L'invention concerne un fer à repasser comprenant un élément chauffant, des moyens de commande du chauffage de l'élément chauffant et un thermostat de réglage.

Lorsqu'on effectue le repassage de tissus, les réglages de température opérés par l'utilisateur à l'aide du thermostat ne sont pas toujours correctement adaptés à la nature du tissu en cours de repassage.

Il peut s'agir d'une erreur de réglage du thermostat ou bien d'une méconnaissance par l'utilisateur de la nature du tissu. Ceci peut avoir de graves conséquences pour le tissu si celui-ci est repassé à une température trop élevée : il peut en effet être détruit. Les problèmes du repassage se caractérisent par :
- une grande variété de textiles
- une grande variété de conditions de température
- une nécessité de détecter assez tôt une éventuelle erreur de réglage et de pouvoir intervenir vite.

Les fabricants de fers à repasser se sont préoccupés de munir les fers à repasser de thermostat en laissant à l'utilisateur le soin de décider lui-même du réglage à opérer. En général, aucun contrôle n'existe pour pallier une éventuelle erreur de l'utilisateur.

Néanmoins, on connait le document JP-A-2 109 600 qui décrit un fer à repasser posé sur un socle renfermant différents organes de commande dont un lecteur d'étiquettes fixées au tissu à repasser. L'utilisateur présente l'étiquette au lecteur qui transfère au fer à repasser la température qui convient au repassage du tissu. Bien évidemment, ce lecteur ne fait que lire des données qui ont été préalablement inscrites sur l'étiquette par le fabricant du tissu. Ces indications ne sont donc pas extraites du tissu lui-même. Il s'ensuit que si l'étiquette est détériorée, par exemple effacée après plusieurs lavages, ou simplement arrachée après plusieurs usages, les informations qu'elle contenait sont perdues. Cette manière d'opérer n'est donc pas fiable.

Aussi est-il utile de disposer d'un dispositif de sécurité plus fiable qui puisse empêcher une erreur de réglage ou avertir l'utilisateur que des réglages erronés ont été programmes.

Ce but est atteint à l'aide d'un fer à repasser qui comprend :
- un détecteur DNA ("détecteur DNA": détecteur de nature de tissu) de la nature des tissus à repasser, le détecteur DNA délivrant un signal SF qui distingue un tissu fragile (SF = 1) d'un tissu non-fragile (SF = 0),
- des moyens pour mémoriser une température limite maximale Tₛ compatible avec les tissus fragiles,
- et des moyens de comparaison qui comparent la température Tₛ avec une température Tₐ programmée sur le thermostat,
   . et, lorsque SF = 0, le détecteur DNA active les moyens de commande pour que le chauffage s'effectue jusqu'à la température Tₐ,
   . et, lorsque SF = 1, le détecteur DNA valide une action desdits moyens de comparaison sur les moyens de commande consistant soit à activer une alarme lorsque Tₐ ≧ Tₛ et à invalider la commande de chauffage ou à effectuer un chauffage doux, soit à autoriser le chauffage jusqu'à la température Tₐ lorsque Tₐ < Tₛ.

Ainsi avantageusement lorsqu'un réglage critique pour le tissu est détecté, le chauffage du fer à repasser est soit automatiquement invalidé, coupé ou réduit pour éviter tout risque de destruction du tissu soit invalidé par l'utilisateur à l'aide d'un bouton approprié. Pour accroître l'efficacité de l'intervention, préférentiellement le fer à repasser présente une faible inertie thermique par exemple assurant un refroidissement de 7°C par seconde environ. Lorsque le réglage de la température Tₐ programmée par l'utilisateur s'avère inférieur à la température Tₛ, aucune intervention n'est effectuée, le chauffage s'opère alors selon la programmation opérée par l'utilisateur.

On peut notamment concevoir deux situations :
- soit préférentiellement que le détecteur DNA opère préalablement puis valide ou non les réglages programmés par l'utilisateur. Alors en cas de déclenchement de l'alarme, le chauffage, de l'élément chauffant du fer à repasser n'est pas permis à puissance électrique élevée. Il est possible de faire fonctionner le fer à puissance réduite pour atteindre une température compatible avec des tissus fragiles (par exemple 120°C).
- soit que le fer à repasser est systématiquement mis en fonction et utilisé, le détecteur DNA n'intervenant qu'après coup. Alors en cas de déclenchement de l'alarme, le chauffage de l'élément chauffant du fer à repasser est réduit.

La température limite maximale Tₛ peut être soit fixée par construction soit ajustée par l'utilisateur à l'aide d'un bouton.

Différents types de détecteur DNA peuvent être utilisés. Préférentiellement selon l'invention avec un premier type de détecteur, on mesure la quantité de charges électrostatiques générées à la surface du tissu par le passage du fer à repasser sur le tissu. Il est alors possible de déterminer un seuil de quantité de charges électrostatiques qui distingue les tissus fragiles des tissus non-fragiles. Il peut s'agir de mesures relatives ou absolues.

La sensibilité du détecteur peut être avantageusement renforcée en plaçant à proximité du détecteur un organe en matière isolante qui par frottement avec le tissu, génère des charges électrostatiques à sa surface.

Selon le taux d'humidité du tissu, il peut arriver que le seuil de la quantité de charges électrostatiques ne soit pas atteint. Il faut donc déterminer si le taux d'humidité est à un niveau compatible pour opérer la mesure de la quantité de charges électrostatiques. Sinon, il faut préalablement réduire le taux d'humidité du tissu.

Pour déterminer le taux d'humidité, on peut utiliser un détecteur d'humidité qui comprend :
- des moyens pour mesurer une résistivité du tissu,
- et des moyens pour mesurer une amplitude moyenne d'un signal électrique issu de variations de résistivité dues au glissement du fer à repasser sur le tissu.

Les moyens pour mesurer la résistivité du tissu comprennent deux bornes conductrices qui affleurent de la semelle du fer à repasser pour pouvoir être mises en contact avec le tissu. On mesure la résistance électrique entre ces deux bornes à l'aide d'un montage approprié. Une valeur faible de la résistance électrique est caractéristique d'un tissu humide. Une valeur élevée de la résistance électrique est caractéristique d'un tissu sec.

Pour réduire l'humidité, le tissu est alors légèrement chauffé. Cela peut être fait soit par le fer lui-même qui est systématiquement démarré à chauffage doux soit par un élément chauffant annexe situé dans le détecteur d'humidité. Pour réduire l'humidité, l'utilisateur fait glisser le fer sur le tissu. Cette opération reste sans conséquence pour le tissu même en cas de mauvais réglages du thermostat car alors l'humidité évite à la température du tissu de s'élever dangereusement avant que lesdites mesures soient effectuées.

Lorsque la valeur de la résistance atteint le niveau prévu pour un tissu sec, une validation de la mesure de la quantité de charges électrostatiques est alors effectuée.

Un autre type de détecteur DNA peut être utilisé. Il est ainsi possible que le détecteur DNA soit muni d'une source de chaleur destinée à chauffer le tissu et d'un ensemble émetteur/récepteur optique qui détermine les variations de réflectance du tissu au cours du chauffage du tissu par ladite source de chaleur. On peut ainsi déterminer un seuil de variation de réflectance délimitant les tissus fragiles et les tissus non fragiles.

Il est possible d'accroître la sécurité d'utilisation en déterminant si le fer à repasser est en cours d'utilisation par exemple s'il est soumis à un mouvement ou si l'utilisateur a la main sur la poignée. Pour cela, on fait précéder la détection de la nature du tissu par une détection d'utilisation. Si le fer à repasser est non utilisé, le chauffage de l'élément chauffant est automatiquement invalidé après un délai court (5 à 10 secondes par exemple). Si le fer à repasser est utilisé, il active alors le détecteur DNA de nature de tissu qui opère corne précédemment. Le détecteur DNA est ainsi commandé par un détecteur DUT (détecteur DUT: détecteur d'utilisation) d'utilisation du fer à repasser qui comprend des moyens pour délivrer un signal UT qui distingue une utilisation (UT = 1) d'une non-utilisation (UT = 0), le détecteur DNA étant activé lorsque UT = 1 et étant désactivé lorsque UT = 0, le détecteur DUT actionnant les moyens de commande pour couper ou réduire le chauffage lorsque UT = 0.

Dans la suite de la description l'expression "Détecteur de NAture de tissu" sera abrégée par l'expression "détecteur DNA", et l'expression "Détecteur d'UTilisation sera abrégée par l'expression "détecteur DUT".

L'invention sera mieux comprise à l'aide des figures suivantes données à titre d' exemples non limitatifs qui représentent :
Figure 1 : un schéma des moyens de détection et de commande d'un fer à repasser selon un mode de réalisation de l'invention.
Figure 2 : un organigramme des principales étapes de détection et de commande.
Figure 3 : une vue cavalière d'un exemple de fer à repasser muni d'un détecteur DNA de la nature de tissu.
Figure 4 : deux schémas A, B d'un détecteur DNA mettant en oeuvre des mesures de charges électrostatiques.
Figure 5 : une vue schématique du dessous d'un fer à repasser muni d'un détecteur d'humidité et d'un détecteur DNA.
Figure 6 : un schéma d'un circuit électrique de mesure de résistivité.
Figure 7 : des courbes représentant les variations DR de résistance et les variations DQ de charges électrostatiques au cours d'une opération de séchage.
Figure 8 : un schéma d'un détecteur DNA mettant en oeuvre des mesures de réflectance.
Figure 9 : un organigramme des principales étapes de détection et de commande dans le cas complémentaire d'un détecteur d'humidité et d'un détecteur d'utilisation.
Figure 10 : un schéma électrique des moyens de détection et de commande d'un fer à repasser dans un mode de réalisation comprenant un détecteur d'utilisation, un détecteur d'humidité et un détecteur de nature de tissu.
Figure 11 : un schéma électrique pour mesurer l'amplitude moyenne d'un signal électrique représentant les variations de charges électrostatiques.
Figure 12 : un exemple d'un circuit de mesure du rythme d'un signal électrique.

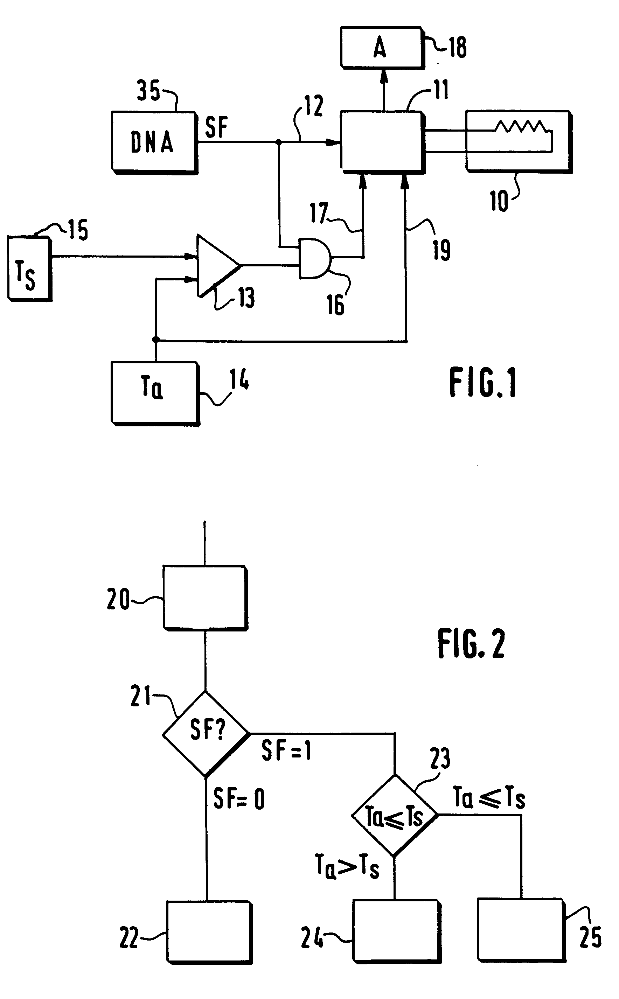

La figure 1 représente les éléments électriques essentiels d'un fer à repasser selon l'invention. L'élément chauffant 10 du fer à repasser reçoit pour chauffer une énergie électrique des moyens de commande 11. Un détecteur DNA de la nature des tissus à repasser délivre un signal de sortie SF qui distingue des tissus fragiles (SF = 1) et des tissus non-fragiles (SF = 0). La sortie du détecteur DNA est directement reliée (connexion 12) aux moyens de commande 11. La connexion 12 active les moyens de commande 11 lorsque SF = 0 pour permettre le chauffage de l'élément chauffant 10. D'autre part, un comparateur 13 compare deux températures Tₐ et Tₛ provenant respectivement d'un thermostat de réglage 14 et de moyens de mémorisation 15. Les moyens de mémorisation 15 peuvent être constitués soit par une valeur de consigne fixée par construction soit par un bouton de réglage mis à la disposition de l'utilisateur. Le comparateur 13 délivre un signal de sortie indiquant si Tₐ est supérieure, égale ou inférieure à la valeur Tₛ. Lorsque le signal de sortie du détecteur DNA détecte un tissu fragile (SF = 1), ce signal SF = 1 valide la sortie du comparateur 13. Ceci est représenté sur la figure 1 par une porte logique ET 16 mais tout autre mode de validation convient. Lorsque SF = 1, la connexion 12 est inactive et la connexion 17 est activée. Selon le signal de sortie du comparateur 13, le signal porté par la connexion 17 peut :
- soit, lorsque Tₐ > Tₛ, activer les moyens de commande 11 pour réduire le chauffage de l'élément chauffant 10 et activer une alarme 18,
- soit, lorsque Tₐ > Tₛ, activer les moyens de commande 11 pour que le chauffage de l'élément chauffant 10 s'opère jusqu'à la température Tₐ programmée (connexion 19).

La figure 2 donne un organigramme des opérations mises en oeuvre :
- mise en opération du détecteur DNA de la nature du tissu (étape 20) et test du signal SF (étape 21),
- lorsque SF = 0, chauffage à la température Tₐ programmée (étape 22),
- lorsque SF = 1, comparaison de la température Tₐ et de la température limite maximale Tₛ (étape 23),
   . lorsque Tₐ > Tₛ, arrêt ou réduction du chauffage et alarme (étape 24),
   . lorsque Tₐ ≦ Tₛ, chauffage à la température Tₐ programmée (étape 25).

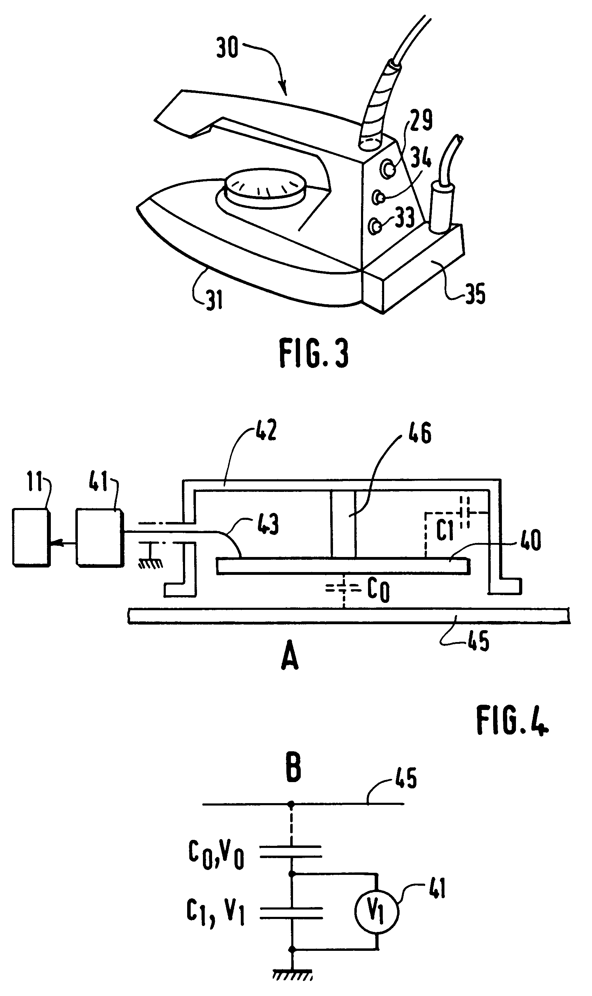

Le détecteur DNA de la nature du tissu va être agencé au fer à repasser de sorte qu'il soit mis en regard avec du tissu lorsque le fer glisse sur le tissu. Le schéma de la figure 3 représente un fer à repasser 30 muni d'un détecteur DNA 35 placé à l'arrière de la semelle du fer. Un bouton de réglage 29 permet à l'utilisateur d'adapter la température Tₛ. Un autre bouton 34 permet une validation manuelle en autorisant l'utilisateur à valider le détecteur DNA.

Selon un mode préférentiel de réalisation de l'invention, le détecteur DNA est un détecteur électrostatique qui mesure les charges électrostatiques apparaissant sur le tissu par le glissement du fer à repasser sur le tissu. Un tel détecteur est représenté sur la figure 4. La figure 4-A représente un électrode métallique 40 reliée électriquement à un circuit 41 de voltmètre électrostatique à haute impédance. L'électrode 40, isolée électriquement par une colonnette isolante 46, est placée dans un blindage 42 pour que la mesure ne soit pas perturbée. On peut utiliser une liaison coaxiale 43 entre l'électrode 40 et le circuit du voltmètre 41. L'électrode 40 est agencée au fer à repasser pour se situer à une faible distance du tissu 45. Ainsi la quantité de charges électrostatiques générée à la surface du tissu par la semelle en mouvement du fer à repasser peut être mesurée, par effet capacitif, à l'aide de l'électrode 40. Entre l'électrode 40 et le tissu 45 apparaît une capacité C₀. Entre l'électrode 40 et le blindage 42 apparaît une capacité C₁.

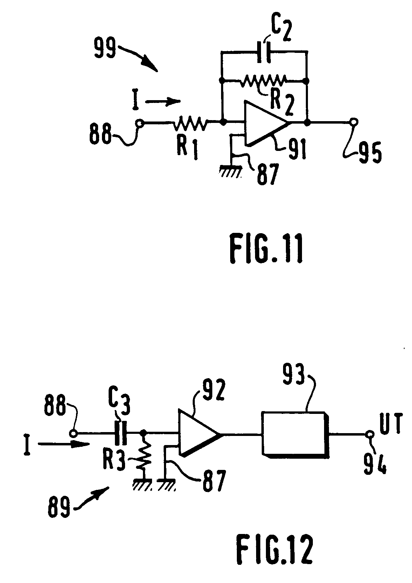

Un signal électrique I apparaît sous la forme d'un signal dont l'amplitude varie au rythme du mouvement du fer sur le tissu. Le circuit de voltmètre électrostatique mesure les amplitudes moyennes de ce signal. La figure 11 représente un exemple de schéma électrique d'un circuit 99 pour déterminer l'amplitude moyenne du signal. Le circuit 99 comprend une résistance R₁ reliée à la borne d'entrée 88 d'amenée du courant I. L'autre extrémité de cette résistance R₁ est reliée à une entrée d'un amplificateur 91 à haute impédance d'entrée. Entre l'entrée et la sortie de cet amplificateur 91, on a disposé un montage formé d'une capacité C₂ et d'une résistance R₂ en parallèle. Sur la sortie 95 apparaît ainsi un signal représentant la valeur moyenne de la quantité de charges électrostatiques.

Le pont capacitif est représenté sur la figure 4-B. En mesurant le potentiel électrostatique V₁ aux bornes de la capacité C₁ on peut déduire la quantité de charges électrostatiques sur le tissu. Expérimentalement, avec des valeurs C₀ et C₁ fixées par construction, la mesure de V₁ permet de déterminer le caractère électrostatique du tissu. A titre indicatif des valeurs comparatives (indiquées en unités arbitraires) sont fournies pour plusieurs types de tissus.

| | |
|---|---|
| Coton | 1 à 5 |
| Viscose | 1 à 5 |
| Acétate | 15 à 20 |
| Polyester | 18 à 24 |
| Acrylique | 15 à 20 |
| Nylon | 14 à 18 |
| Laine | 18 à 24 |
| Soie | 14 à 20 |

On observe que la plupart des tissus qui nécessitent des températures de repassage pas trop élevées présentent le caractère électrostatique le plus élevé. Selon l'invention, il est donc possible de fixer un seuil Qₛ de quantité de charges électrostatiques qui permet de situer une séparation entre les tissus fragiles et les tissus non-fragiles. Le franchissement de ce seuil est détecté par le circuit 41.

On peut alors utiliser ce seuil Qₛ pour examiner si le réglage de la température Tₐ programmée par l'utilisateur est compatible ou non avec la fragilité du tissu. En cas d'incompatibilité, une alarme est déclenchée et le chauffage de l'élément chauffant est invalidé ou réduit si l'élément chauffant était déjà activé. Pour que l'efficacité du refroidissement soit garantie, il faut que le fer à repasser possède une faible inertie thermique.

Il peut être prévu qu'en cas du déclenchement de l'alarme, l'utilisateur puisse néanmoins outrepasser cette consigne en invalidant l'alarme à l'aide d'un bouton 34 approprié (figure 3). En effet, le niveau de déclenchement de l'alarme peut être réglé pour un degré de sécurité élevé. Un utilisateur averti peut alors, dans des cas spécifiques, déroger à cette interdiction.

Les mesures peuvent être des mesures absolues ce qui nécessite d'effectuer une opération de remise à zéro du détecteur par exemple en court-circuitant les capacités du détecteur avant chaque mesure. Un autre bouton 33 peut également commander soit un niveau zéro soit un niveau de référence Q_{R} de charges électrostatiques. D'autres dispositions sont possibles.

Les mesures peuvent également être des mesures relatives ce qui nécessite d'effectuer une opération de tarage sur un tissu de référence. Ce tarage peut par exemple être obtenu en faisant glisser le fer à repasser sur un tissu de nature connue, par exemple du coton, et à prendre comme niveau de référence Q_{R} le niveau de charges électrostatiques ainsi atteint. Le niveau de référence Q_{R} est validé par l'utilisateur en activant le bouton poussoir 33 (figure 3).

Il est possible d'accroître la quantité de charges électrostatiques générées en munissant le fer à repasser d'un organe constitué d'un matériau isolant qui est agencé au fer pour générer par frottements des charges électrostatiques lorsque le fer à repasser glisse sur le tissu. Il peut être formé par exemple d'une plaquette située à proximité du détecteur DNA. La plaquette peut par exemple être en Téflon*, en verre, en tôle émaillée, en Kapton*.
*marque déposée

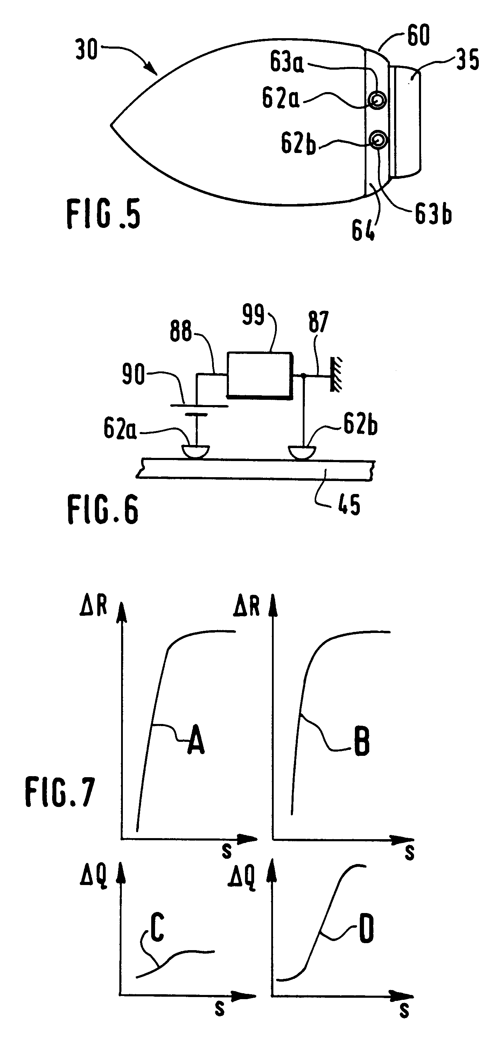

Une mesure correcte de la quantité de charges électrostatiques par le détecteur DNA peut nécessiter de réduire préalablement le taux d'humidité du tissu. Pour déterminer ce taux d'humidité, on utilise un détecteur d'humidité DHU qui mesure la résistance électrique du tissu entre deux bornes de contact. La figure 5 représente une vue schématique du dessous d'un fer à repasser 30 muni d'un détecteur d'humidité 60 et d'un détecteur DNA 35. Le détecteur d'humidité 60 comprend deux bornes 62ₐ, 62_{b} qui ont préférentiellement une forme arrondie, hémisphérique par exemple, pour pouvoir glisser aisément sur le tissu. Des bornes de 5 mm à 10 mm de diamètre, par exemple en acier inoxydable, conviennent. Ces bornes peuvent être montées sur un support élastique pour bien s'appliquer sur le tissu sans néanmoins laisser de traces. Un circuit de mesure détermine la valeur de la résistance électrique du tissu entre les deux bornes. Si ladite valeur est faible, le tissu est humide. Si ladite valeur est élevée, le tissu est sec. Les bornes sont placées dans des logements 63ₐ, 63_{b} ménagés dans une plaquette 64.

La figure 6 représente un schéma d'un circuit électrique de mesure de la résistivité. Les bornes 62ₐ, 62_{b}, qui sont en contact avec le tissu 45, sont réunies à une alimentation électrique 90 et à un circuit 99 de mesure du courant électrique I traversant le circuit. Ce circuit 99 est par exemple celui de la figure 11. L'autre entrée de l'amplificateur 91 peut être réunie à la masse. Dans ce cas, la semelle du fer à repasser peut se substituer à la borne 62_{b}. Le détecteur d'humidité comprend alors une borne 62ₐ et la semelle 31 comme seconde borne.

Lorsque l'on souhaite accroître la quantité de charges électrostatiques générées, la plaquette 64 peut remplir cette fonction. Elle peut être en un matériau isolant électriquement, par exemple du Téflon*, du verre, une tôle émaillée, du Kapton*. Le matériau doit avoir une tenue suffisante en température pour être mis en contact sans se détériorer avec des tissus plus ou moins chauds.

Pour que le détecteur électrostatique 35 puisse fonctionner dans plusieurs directions de glissement du fer à repasser, il est possible que la plaquette 64 entoure partiellement ou totalement l'électrode 40 de mesure. Par exemple, une forme en L ou circulaire peut convenir.

Lorsque le détecteur d'humidité 60 décèle une humidité trop élevée, on chauffe modérément le fer à repasser tout en continuant à mesurer le taux d'humidité. Lorsque le détecteur d'humidité détermine une résistance élevée caractéristique d'un tissu sec, la mesure du détecteur DNA est alors prise en compte de la même manière que précédemment.

Pour réduire le taux d'humidité, il est possible de chauffer le tissu non pas avec l'élément chauffant du fer mais avec un élément chauffant annexe (petite plaque chauffante) compris dans le détecteur d'humidité. Ceci présente l'avantage de séparer les deux opérations de chauffage liées l'une au repassage et l'autre à la deshumidification. L'inertie de l'élément chauffant annexe peut alors être très faible. Le détecteur d'humidité opère alors plus rapidement avec un risque très limité d'endommager le tissu.

La figure 7 représente des courbes des variations DR de la résistance et des variations DQ de charges électrostatiques au cours d'une opération de deshumidification pour un fer à repasser tel que représenté sur la figure 5. En posant puis en faisant glisser le fer à repasser dans le sens de sa pointe avant, avec une semelle légèrement chauffée, le détecteur d'humidité 60 rencontre des parties de tissu de plus en plus sèches (sur une longueur de semelle de fer). On observe alors des courbes A et C pour du coton et des courbes B et D pour de l'acrylique en fonction du degré de séchage. Les courbes C et D se rapportent aux variations DQ de charges électrostatiques. Les courbes A et B se rapportent aux variations DR de résistance électrique. Elles sont fournies en unités arbitraires. Lorsque la résistance devient élevée, la quantité de charges électrostatiques s'accroît en relation avec la nature du tissu. Dans la réalité, les tissus n'ont pas une humidité constante, ce qui provoque des fluctuations du signal en fonction du mouvement du fer à repasser.

Selon un autre mode de réalisation, il est possible pour le détecteur DNA de prendre en considération une mesure de réflectance du tissu. Cette méthode est bien sûr dépendante des tissus eux-mêmes et ne peut s'appliquer dans tous les cas. En particulier des tissus noirs ayant une texture ondulée peuvent donner des résultats insuffisants. Néanmoins, elle peut s'appliquer à beaucoup d'autres tissus et l'aide ainsi apportée à l'utilisateur constitue une sécurité appréciable.

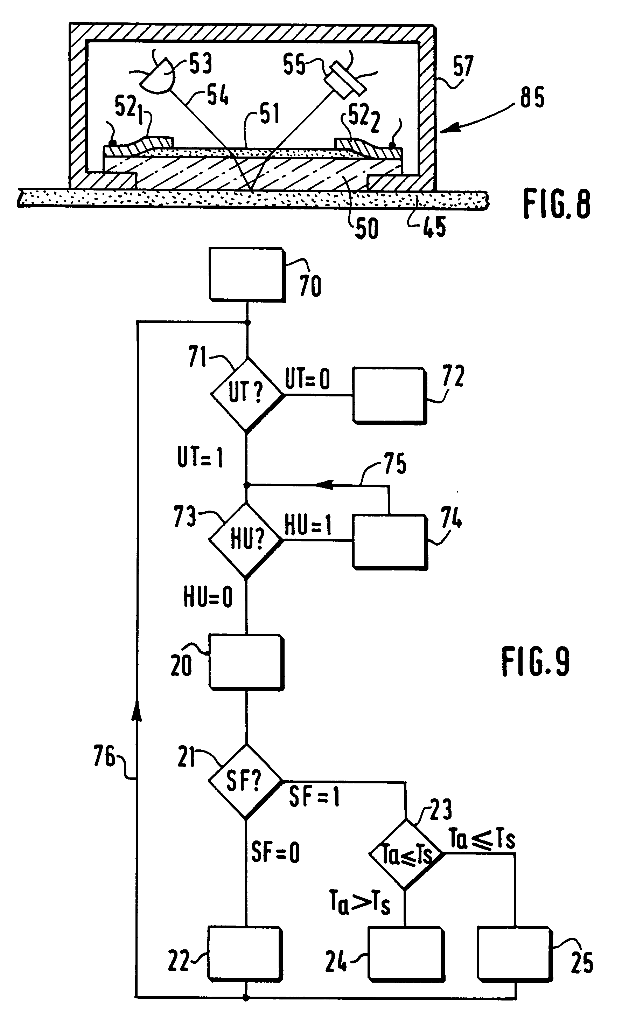

La figure 8 représente un détecteur DNA 85 de la nature du tissu mettant en oeuvre des mesures optiques. Il comprend un élément chauffant annexe qui chauffe, à une température judicieusement déterminée, une faible surface de tissu, le comportement de cette faible surface étant observé par voie optique.

L'élément chauffant annexe est constitué d'un substrat 50 sur lequel a été déposée une couche mince 51 d'un matériau assez résistif pour former une résistance chauffante et également transparent au rayonnement lumineux utilisé. Des contacts électriques 52₁, 52₂ permettent d'appporter l'énergie électrique nécessaire. La couche mince 51 chauffe le substrat 50 qui à son tour chauffe le tissu 45 placé en contact lorsque le fer à repasser glisse sur le tissu. La température maximale que peut atteindre le tissu est ajustée pour que le tissu ne soit pas endommagé. Néanmoins, les variations de réflectance des tissus fragiles doivent être suffisantes pour être détectées. Un émetteur de lumière 53, par exemple une diode électroluminescente, émet un faisceau lumineux 54 qui après réflexion sur le tissu 45 est détecté par le détecteur 55 par exemple un phototransistor. L'ensemble des éléments est placé dans un boîtier 57. Des variations de réflectance ainsi détectées, on définit un seuil de variation au-delà duquel une alarme est déclenchée.

Pour accroître la sécurité d'utilisation du fer, il est possible de commander le détecteur DNA de la nature du tissu par un détecteur d'utilisation. Il s'agit par exemple d'un détecteur de mouvement, d'un détecteur de préhension de la poignée ou d'un détecteur électrostatique. Un détecteur de mouvement est par exemple connu à partir du brevet européen EP 0227150. Lorsque le détecteur électrostatique ou le détecteur d'humidité agencés au fer à repasser sont mis en mouvement, ils délivrent un signal électrique dont la valeur moyenne permet de déterminer soit la nature du tissu soit le degré d'humidité. Ce signal électrique varie au rythme du mouvement du fer à repasser. En détectant les fronts montants et descendants du signal délivré par l'un ou l'autre de ces détecteurs, il est ainsi possible que ces derniers effectuent des tâches dévolues au détecteur d'utilisation. Un détecteur électrostatique ou un détecteur d'humidité peut ainsi être utilisé pour constituer un détecteur de mouvement. Dans ce cas, le fer à repasser comprend en outre des moyens pour détecter un mouvement du fer à repasser en mesurant un rythme de variations dudit signal électrique issu de l'un ou de l'autre détecteur. Lorsque le fer à repasser n'est pas en utilisation, on ne permet pas le chauffage de l'élément chauffant. Lorsque le fer à repasser est en utilisation, le chauffage de l'élément chauffant est soumis au contrôle du détecteur DNA de nature de tissu comme précédemment.

La figure 12 représente un exemple de circuit 89 permettant de déterminer le nombre d'alternances. Il comprend une capacité C₃ et une résistance R₃ connectées à une entrée d'un amplificateur 92 à haute impédance d'entrée. Ce circuit dérive le signal I et fournit des impulsions à chaque front de montée et de descente du signal. Ces impulsions sont ensuite comptées dans un compteur 93 qui délivre sur une sortie 94 un signal S lorsqu'un nombre nul ou très limité d'impulsions (par exemple 1 à 3) est apparu au cours de la durée prédéterminée.

Si le fer à repasser cesse d'être utilisé comme par exemple pour changer de tissu, le chauffage de l'élément chauffant du fer à repasser est automatiquement invalidé. Ceci permet au fer à repasser de se refroidir rapidement préalablement à l'utilisation du détecteur de nature de tissus DNA (en particulier avec un fer à faible inertie thermique). Ceci offre une sécurité avant que le fer à repasser ne soit replacé sur un nouveau tissu qui pourrait être fragile. Quand le détecteur de nature du tissu est du type électrostatique, on peut effectuer le zéro en court-circuitant à la masse l'électrode de signal pendant un court instant. Ce court-circuit peut être réalisé automatiquement électroniquement, par exemple, pendant la période de non-utilisation du fer à repasser.

Lorsque le détecteur d'utilisation indique que l'utilisateur réutilise le fer, le signal du détecteur d'utilisation est alors pris en compte après une courte temporisation de 1 à 2 secondes. Ce temps est en général suffisant après la prise en main pour poser le fer sur le tissu à repasser.

La figure 9 représente un organigramme des principales étapes de détection et de commande dans le cas d'un fer à repasser muni d'un détecteur d'utilisation, d'un détecteur d'humidité et d'un détecteur de nature de tissu.

Etape 70 : le fer à repasser est mis en fonctionnement. L'élément chauffant peut être commandé pour délivrer un chauffage programmé, réduit ou pas de chauffage.

Etape 71 : le détecteur d'utilisation détecte si le fer à repasser est en utilisation (UT = 1) ou non utilisé (UT = 0). Si UT = 0, le fer à repasser est soit arrêté soit mis en chauffage réduit (étape 72). La mise en chauffage réduit assure le préchauffage. Si UT = 1, ce signal valide le fonctionnement du détecteur d'humidité. Une certaine temporisation peut être prévue pour laisser à l'utilisateur le temps de placer le fer à repasser sur le tissu et assurer une mesure correcte.

Etape 73 : le détecteur d'humidité détermine si le tissu est humide (HU = 1) ou sec (HU = 0).

Lorsque HU = 1, le fer à repasser est mis (étape 74) en chauffage doux pour procéder à la deshumidification du tissu et permettre les mesures ultérieures. Une boucle 75 est établie jusqu'à ce que la mesure se rapporte à un tissu non-humide.

Lorsque HU = 0, ce signal valide le fonctionnement du détecteur DNA de nature de tissu. Celui-ci opère comme cela a été décrit préalablement.

Lorsque le fer à repasser opère en chauffant selon la température Tₐ programmée (étapes 22 et 25), une boucle de contrôle 76 est établie afin de détecter régulièrement l'utilisation du fer à repasser. Tout arrêt d'utilisation pendant un temps prédéterminé met alors le fer à repasser soit à l'arrêt soit en chauffage réduit.

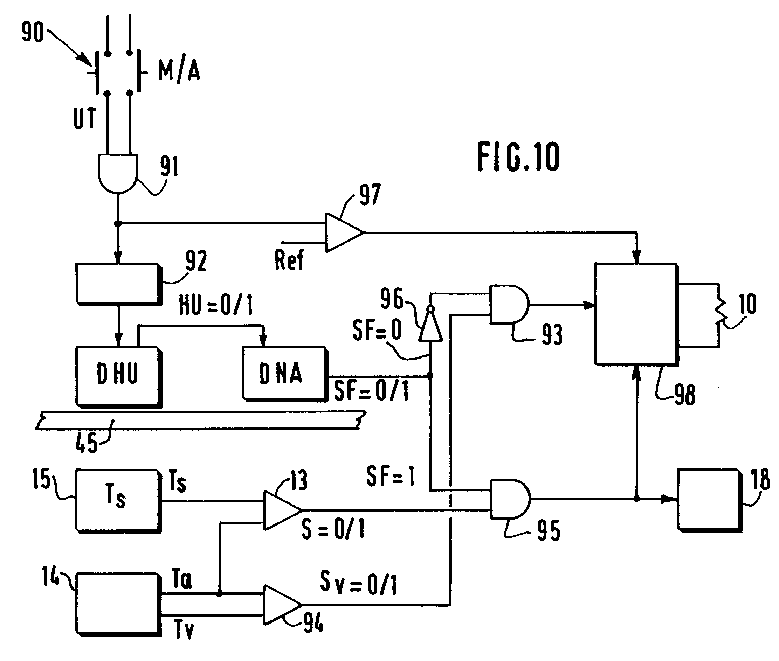

Les informations issues des différents détecteurs sont ensuite traitées par exemple selon le schéma de la figure 10. L'interrupteur marche-arrêt M/A et le contacteur 90, qui détecte la saisie de la poignée par l'utilisateur, sont réunis à une porte ET 91. Lorsque UT = 1 et M/A actionné, la porte 91 met en fonctionnement une temporisation 92 qui après un délai court (1 à 2 secondes par exemple) active le détecteur d'humidité DHU. Lorsque le tissu est sec (HU = 0) le détecteur DNA est activé.

Si le tissu n'est pas fragile (SF = 0), une porte ET 93 (qui reçoit SF inversé par un inverseur 96) valide la sortie d'un comparateur 94 qui compare la température Tₐ programmée sur le thermostat et la température vraie Tᵥ du fer à repasser :
. lorsque Tᵥ ≦ Tₐ, à la sortie du comparateur 94, on a Sᵥ = 1 et la porte ET 93 active les moyens de chauffage 98,
. lorsque Tᵥ > Tₐ, Sᵥ = 0, la porte ET 93 désactive les moyens de chauffage 98.

Une comparaison de la température Tₛ et de la température Tₐ est effectuée dans le comparateur 13. Lorsque Tₐ < Tₛ la sortie S du comparateur 13 est à l'état 1 (S = 1). Lorsque Tₐ > Tₛ la sortie S est à l'état 0 (S = 0). Si le tissu est fragile (SF = 1), la sortie de ce comparateur entre dans une porte ET 95 qui reçoit également le signal SF = 1. Lorsque la sortie de la porte 95 est à l'état 1, elle active les moyens de chauffage 98. Lorsque la sortie de la porte 95 est à l'état 0, elle désactive les moyens de chauffage 98 et active l'alarme 18.

Lorsque le tissu est humide (HU = 1), le détecteur DNA est désactivé et les moyens de chauffage ne sont pas sollicités par les actions contrôlées par le signal SF, qui viennent d'être décrites ci-dessus. En effet, il est prévu que les moyens de chauffage 98 puissent être maintenus à un chauffage doux sous le contrôle d'un comparateur 97. Celui-ci reçoit :
. d'une part, la sortie de la porte 91 qui détecte une mise en marche et une utilisation du fer à repasser,
. et d'autre part, une référence de consigne déterminant un chauffage doux.

En cas de tissu humide (HU = 1), c'est ce chauffage doux qui agit pour obtenir la déshumidification du tissu.

## Revendications

1. Fer à repasser comprenant un élément chauffant (10), des moyens (11) de commande de chauffage de l'élément chauffant et un thermostat (14) de réglage caractérisé en ce qu'il comprend :
- un détecteur DNA (35, 85) de la nature des tissus à repasser, le détecteur DNA délivrant un signal SF qui distingue un tissu fragile, SF = 1, d'un tissu non-fragile, SF = 0,
- des moyens (15) pour mémoriser une température limite maximale Tₛ compatible avec les tissus fragiles,
- et des moyens (13) de comparaison qui comparent la température Tₛ avec une température Tₐ programmée sur le thermostat,
. et, lorsque SF = 0, le détecteur DNA active les moyens de commande pour que le chauffage s'effectue jusqu'à la température Tₐ,
. et, lorsque SF = 1, le détecteur DNA valide une action desdits moyens de comparaison sur les moyens (11) de commande consistant soit à activer une alarme (18) lorsque Tₐ ≧ Tₛ et à invalider la commande de chauffage ou à effectuer un chauffage doux, soit à autoriser le chauffage jusqu'à la température Tₐ lorsque Tₐ < Tₛ.

2. Fer à repasser selon la revendication 1 caractérisé en ce que le détecteur DNA est un détecteur électrostatique (35) qui comprend :
- des moyens (40, 42, 43, 46) pour capter des charges électrostatiques créées sur le tissu par glissement du fer à repasser,
- des moyens (41, 99) pour mesurer une amplitude moyenne d'un signal électrique issu de variations des charges électrostatiques.

3. Fer à repasser selon la revendication 2 caractérisé en ce qu'il est muni d'un organe, constitué d'un matériau isolant, qui est agencé au fer pour générer par frottements des charges électrostatiques lorsque le fer à repasser glisse sur le tissu.

4. Fer à repasser selon la revendication 3 caractérisé en ce que l'organe entoure partiellement ou totalement le détecteur électrostatique.

5. Fer à repasser selon une des revendications 2 à 4 caractérisé en ce que le matériau isolant est du Téflon, du verre, de l'émail, du Kapton.

6. Fer à repasser selon une des revendications 2 à 5 caractérisé en ce que le détecteur DNA est commandé par un détecteur d'humidité (60) du tissu qui comprend :
- des moyens (62ₐ, 62_{b}) pour mesurer une résistivité du tissu,
- et des moyens (99) pour mesurer une amplitude moyenne d'un signal électrique issu de variations de résistivité dues au glissement du fer à repasser sur le tissu.

7. Fer à repasser selon la revendication 6 caractérisé en ce que les moyens pour mesurer la résistivité du tissu comprennent au moins une borne (62ₐ) (62_{b}) conductrice qui affleure de la semelle du fer à repasser pour pouvoir être mise en contact avec le tissu.

8. Fer à repasser selon la revendication 1 caractérisé en ce que le détecteur DNA est un détecteur optique (85) qui comprend des moyens (53, 55) pour mesurer une réflectance du tissu.

9. Fer à repasser selon une des revendications 1 à 8 caractérisé en ce que le détecteur DNA est commandé par un détecteur DUT d'utilisation du fer à repasser qui comprend des moyens (89) pour délivrer un signal UT qui distingue une utilisation (UT = 1) d'une non-utilisation (UT = 0), le détecteur DNA étant activé lorsque UT = 1 et étant désactivé lorsque UT = 0, le détecteur DUT actionnant les moyens (11) de commande pour couper ou réduire le chauffage lorsque UT = 0.

10. Fer à repasser selon une des revendications 8 ou 9 caractérisé en ce que le détecteur d'utilisation est le détecteur électrostatique (35) ou le détecteur d'humidité (60), le fer à repasser comprenant en outre des moyens (89) pour détecter un mouvement du fer à repasser en mesurant un rythme de variations dudit signal électrique issu de l'un ou de l'autre détecteur.

## Claims

1. An iron comprising a heating element (10), heating-control means (11) for the heating element, and a control thermostat (14), characterised in that it comprises:
- a DNA detector (35, 85) for the nature of fabrics to be ironed, the DNA detector supplying a signal SF which distinguishes a delicate fabric, SF = 1, from a non-delicate fabric, SF = 0,
- storage means (15) for storing a maximum temperature limit Tₛ corresponding to delicate fabrics,
- and comparison means (13) which compare the maximum temperature limit Tₛ with a temperature Tₐ programmed by means of the thermostat,
. and, when SF= 0, the DNA detector activates the control means to provide heating to the temperature Tₐ,
. and, when the SF = 1, the DNA detector validates the comparison means to act upon the control means (11) either so as to activate an alarm (18) when Tₐ ≧ Tₛ, and to invalidate the heating control or to perform moderate heating, or to enable heating to the programmed temperature Tₐ when Tₐ < Tₛ.

2. An iron as claimed in Claim 1, characterised in that the DNA detector is an electrostatic detector (35) comprising:
- means (40, 42, 43, 46) for sensing electrostatic charges produced at the fabric by the movement of the iron,
- means (41, 99) for measuring an average amplitude of an electric signal resulting from electrostatic-charge variations.

3. An iron as claimed in Claim 2, characterised in that it comprises an element made of an insulating material and arranged on the iron to generate electrostatic charges by frictional contact as the iron slides on the fabric.

4. An iron as claimed in Claim 3, characterised in that the element partly or wholly surrounds the electrostatic detector.

5. An iron as claimed in any one of the Claims 2 to 4, characterised in that the insulating material is Teflon, glass, enamel, or Kapton.

6. An iron as claimed in any one of the Claims 2 to 5, characterised in that the DNA detector is controlled by a
a fabric-humidity detector (60) comprising:
- means (62ₐ, 62_{b}) for measuring a resistivity of the fabric,
- and means (99) for measuring an average amplitude of an electric signal resulting from resistivity variations caused by the movement of the iron on the fabric.

7. An iron as claimed in Claim 6, characterised in that the means for measuring the resistivity of the fabric comprise at least one electrode (62ₐ), (62_{b}) which is flush with the soleplate of the iron to enable it to be brought into contact with the fabric.

8. An iron as claimed in Claim 1, characterised in that the DNA detector is an optical detector (85) comprising means (53, 55) for measuring a reflectance of the fabric.

9. An iron as claimed in any one of the Claims 1 to 8, characterised in that the DNA detector is controlled by a detector DUT for the state of use of the iron, which detector comprises means (89) for supplying a signal (UT) to distinguish between use (UT = 1) and non-use (UT = 0), the DNA detector being activated when UT = 1 and being deactivated when UT = 0, the detector DUT activating the control means (11) to turn off or reduce the heating when UT = 0.

10. An iron as claimed in Claim 8 or 9, characterised in that the state-of-use detector is the electrostatic detector (35) or the humidity detector (60), the iron further comprising means (89) for detecting a movement of the iron by measuring a rhythm of variations of said electric signal obtained from one detector or the other detector.

## Patentansprüche

1. Ein Bügeleisen mit einem Heizelement (10), Temperatursteuermitteln (11) des Heizelements und einen Reglerthermostat (14) mit folgenden Merkmalen :
- ein DNA-Sortenfühler (35, 85) der zu bügelnden Textilien, der DNA-Fühler sendet ein Signal SF, das delikate Textilien, SF = 1, von nichtdelikaten Textilien, SF = 0, unterscheidet,
- Speichermittel (15) zur Speicherung einer maximalen Grenztemperatur Tₛ, geeignet für delikate Textilien,
- und Vergleichsmittel (13) zum Vergleich der Temperatur Tₛ mit der Temperatur Tₐ, auf dem Thermostat programmiert,
. und, wenn SF = 0, aktiviert der DNA-Fühler die Steuermittel, damit eine Beheizung bis zur Temperatur Tₐ vorgenommen wird,
. und, wenn SF = 1, bestätigt der DNA-Fühler einen Vorgang der besagten Vergleichsmittel über die Steuermittel (11), die darin bestehen, entweder ein Warnsignal (18) auszulösen, wenn Tₐ ≧ Tₛ, und die Heizsteuerung zu unterbrechen, oder eine niedere Beheizung vorzunehmen, d.h. die Beheizung bis zur Temperatur Tₐ zuzulassen, wenn Tₐ < Tₛ.

2. Ein Bügeleisen laut Anspruch 1, mit dem Merkmal, daß der DNA-Fühler ein elektrostatischer Fühler (35) ist, der aus folgendem besteht :
- Mitteln (40, 42, 43, 46) zum Empfang der elektrostatischen Ladungen, die durch das Gleiten des Bügeleisens auf der Textilie entstehen,
- Mitteln (41, 99) zur Messung der mittleren Größe eines elektrischen Signals, das aus elektrostatischen Ladungsvariationen entsteht.

3. Ein Bügeleisen laut Anspruch 2, mit dem Merkmal, daß es mit einem Teil aus isolierendem Material versehen ist, das so am Bügeleisen angebracht ist, daß es durch Reibung elektrostatische Ladungen erzeugt, wenn das Bügeleisen über die Textilie gleitet.

4. Ein Bügeleisen laut Anspruch 3, mit dem Merkmal, daß das Teil den elektrostatischen Fühler teilweise oder völlig umschließt.

5. Ein Bügeleisen laut den Ansprüchen 2 bis 4, mit dem Merkmal, daß das isolierende Material aus Téflon, Glas, Email oder Kapton ist.

6. Ein Bügeleisen laut den Ansprüchen 2 bis 5, mit dem Merkmal, daß der DNA-Fühler über einen Textilfeuchtigkeitsfühler (60) gesteuert wird, der folgendes enthält :
- Mittel (62ₐ, 62_{b}) zur Messung des spezifischen Widerstands der Textilie,
- und Mittel (99) zur Messung der mittleren Größe eines elektrischen Signals, das beim Gleiten des Bügeleisens über die Textilie aus den Variationen des spezifischen Widerstands entsteht.

7. Ein Bügeleisen laut Anspruch 6, mit dem Merkmal, daß die Mittel zur Messung des spezifischen Widerstands der Textilie mindesten über einen Kontaktanschluß (62ₐ, 62_{b}) verfügen, der von der Sohle des Bügeleisens mit der Textilie in Verbindung gebracht werden kann, um diese abzutasten.

8. Ein Bügeleisen laut Anspruch 1, mit dem Merkmal, daß der DNA-Fühler ein optischer Fühler (85) ist, der über Mittel (53, 55) verfügt, um eine Reflektierung der Textilie zu messen.

9. Ein Bügeleisen laut den Ansprüchen 1 bis 8, mit dem Merkmal, daß der DNA-Fühler über einen DUT-Verwendungsfühler des Bügeleisens gesteuert wird, der über Mittel (89) verfügt, um ein Signal UT zu senden, das eine Verwendung (UT = 1) von einer Nichtverwendung (UT = 0) unterscheidet, der DNA-Fühler wird bei UT = 1 aktiviert und bei UT = 0 desaktiviert, der DUT-Fühler aktiviert die Steuermittel (11), um die Beheizung bei UT = 0 zu unterbrechen oder zu vermindern.

10. Ein Bügeleisen laut den Ansprüchen 8 oder 9, mit dem Merkmal, daß der Verwendungsfühler der elektrostatische Fühler (35) oder der Feuchtigkeitsfühler (60) ist, das Bügeleisen verfügt dazu über Mittel (89), um eine Bewegung des Bügeleisens zu ermitteln, indem es den Variationsryhthmus des besagten elektrischen, von dem einen oder anderen Fühler gesandten Signals mißt.
